# EUROPEAN PATENT APPLICATION

(11) **EP 0 838 685 A2**
(43) Date of publication of application: **29.04.1998**
(21) Application number: 97250313.0
(22) Date of filing: 22.10.1997
(51) Int. Cl.: G01R 1/073

(54) **Probe card with needle-like probes resiliently supported by rigid substrate and process for fabricating thereof**

(30) Priority: 23.10.1996 JP 280840/96
(71) Applicant: NEC CORPORATION, Tokyo (JP)
(72) Inventor: Soejima, Koji, Minato-ku, Tokyo (JP); Senba, Naoji, Minato-ku, Tokyo (JP); Shimada, Yuzo, Minato-ku, Tokyo (JP)
(74) Representative: Patentanwälte Wenzel & Kalkoff

(57) **Abstract**

A probe card is used in a testing apparatus for connecting the testing apparatus to electrodes of an integrated circuit device, and has needle-like conductive probes (27) provided on a resilient layer (21c) supported by a ceramic substrate (21b) in a cantilever fashion so that the needle-like conductive probes absorbs the irregularity of the electrodes.

## Description

### FIELD OF THE INVENTION

This invention relates to a semiconductor diagnosis technology and, more particularly, to a structure of a probe card and a process for fabricating the probe card.

### DESCRIPTION OF THE RELATED ART

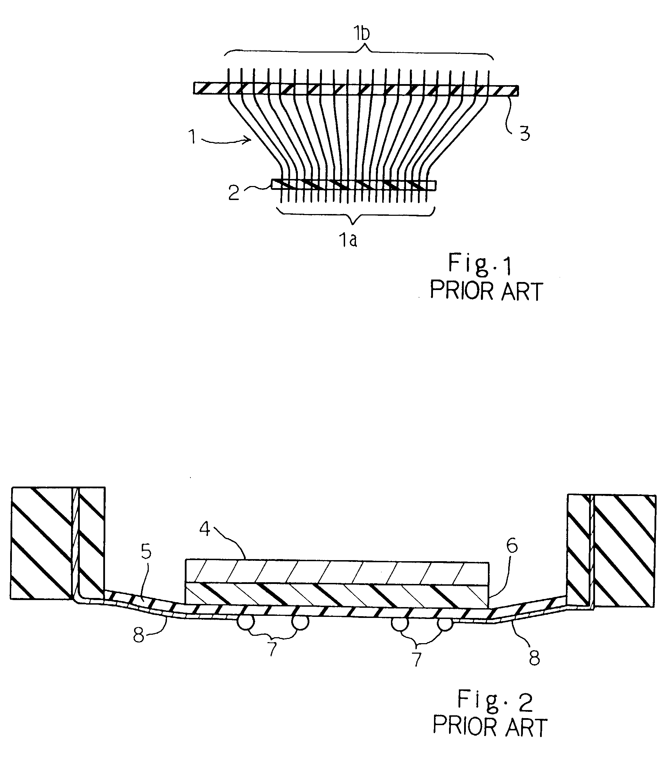

Figure 1 illustrates a prior art probe card. The prior art probe card is called as "tungsten pin probe card". The prior art tungsten pin probe card includes a plurality of tungsten pins 1. The tungsten pins 1 are arranged in an array, and are electrically isolated from one another. A tungsten pin jig 2 holds the tungsten pins 1 at high density, and contact portions la project from the tungsten pin jig 2. The other end portions 1b of the tungsten pins 1 pass through a tungsten pin supporter 3 at low density, and project from the tungsten pin supporter 3. Wirings (not shown) are connected to the other end portions 1b, and the tungsten pin jig 2 brings the contact portions la into contact with electrodes of an integrated circuit device (not shown). A testing apparatus (not shown) communicates with the integrated circuit device through the prior art tungsten pin probe card.

Figure 2 illustrates another prior art probe card called as "membrane probe card". The prior art membrane probe card comprises a supporting board 4. A film 5 is fixed to the supporting board 4 by means of an elastomer layer 6. Conductive bumps 7 are arrayed on the film 5, and are selectively connected to wirings 8. The conductive bumps 7 are brought into contact with electrodes of an integrated circuit device (not shown), and a testing apparatus (not shown) communicates with the integrated circuit device through the prior art membrane probe card.

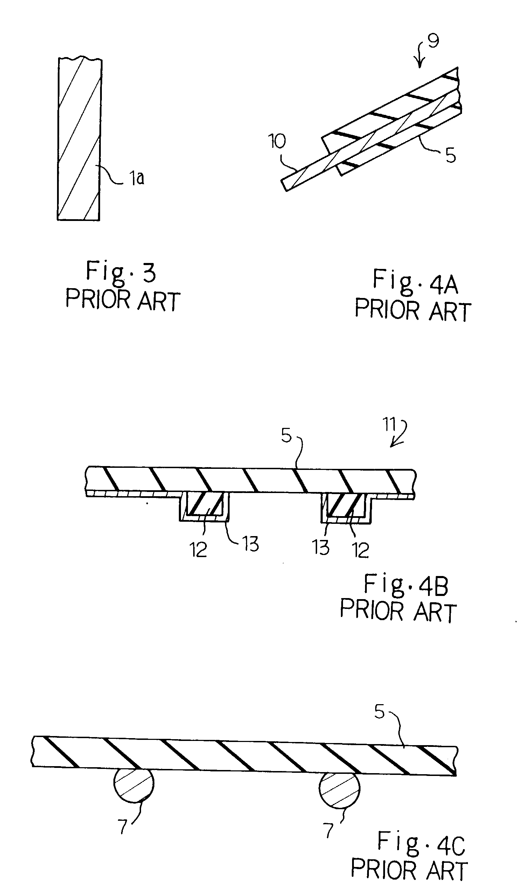

In the prior art tungsten pin probe card, the contact portion la of the tungsten pin 1 is without any protective film as shown in figure 3. However, the prior art membrane probe card has various contact portions. A prior art membrane probe card 9 has a contact portion 10 projecting from the film 5 as shown in figure 4A, and is plated with nickel or gold. Another prior art membrane probe card 11 has insulating bumps 12 of polyimide, and the polyimide bumps 12 are covered with conductive strips 13, respectively, as shown in figure 4B. The conductive strips 13 serve as the contact portions. Figure 4C illustrates the contact portions implemented by the conductive bumps 7 arrayed on the film 5 as similar to the membrane probe card shown in figure 3.

The contact portions 1a/10/12/7 are laid on the pattern of the electrodes of the integrated circuit device, and the space between the adjacent contact portions ranges from 40 microns to 100 microns. The prior art tungsten pin probe card encounters a problem in that the manufacturer hardly decreases the pitch ofthe contact portions 1a. Moreover, the production cost is increased together with the tungsten pins 1.

On the other hand, the prior art membrane probe card encounters a problem in a short stroke thereof. In detail, it is possible to arrange the contact portions such as conductive layers on the polyimide bumps 12/13 and the conductive bumps 7 at a fine pitch. However, the height ofthe bumps 13/7 is smaller than the diameter of the bottom surface, and, accordingly, the bumps 13/7 has an aspect ratio less than 1. When the bumps 13/7 are miniaturized, the height is decreased, and the margin is a quite little. For this reason, the prior art membrane probe card hardly takes up the dispersion of the height of the electrodes.

### SUMMARY OF THE INVENTION

It is therefore an important object of the present invention to provide a probe card which absorbs large irregularity in the height of electrodes without sacrifice of fine pitch.

It is also an important object of the present invention to provide a process for fabricating the probe card.

To accomplish the object, the present invention proposes to resiliently support needle-like conductive probe.

In accordance with one aspect of the present invention, there is provided a probe card for testing a semiconductor integrated circuit having electrodes comprising a rigid substrate having a first portion, a resilient layer formed on the first portion, a conductive wiring structure formed on the resilient layer, and a plurality of needle-like conductive probes connected to the conductive wiring structure over the resilient layer and each including a silicon whisker projecting in a vertical direction to the first portion and a conductive layer covering the silicon whisker.

In accordance with another aspect of the present invention, there is provided a process for fabricating a probe card, comprising the steps of: a) preparing a rigid substrate having a groove filled with a certain material; b) forming a resilient layer extending over the rigid substrate and the layer of the certain material; c) forming a conductive wiring layer structure on the resilient layer having a hole where the layer of the certain material is exposed; d) connecting needle-like conductive probes formed from silicon whiskers to the conductive wiring layer structure; and e) removing the certain material for evacuating the layer of the certain material from the groove so as to provide the needle-like conductive probes on the resilient layer supported by the rigid substrate in a cantilever fashion.

### BRIEF DESCRIPTION OF THE DRAWINGS

The features and advantages of the probe card and the process for fabricating thereof will be more clearly understood from the following description taken in conjunction with the accompanying drawings in which:
Fig. 1 is a schematic cross sectional view showing the prior art tungsten pin probe card;
Fig. 2 is a schematic cross sectional view showing the prior art membrane probe card;
Fig. 3 is a cross sectional view showing the contact portion of the prior art tungsten pin probe card;
Figs. 4A to 4C are cross sectional views showing the contact portions of the prior art membrane probe cards;
Fig. 5 is a flow chart showing a process for fabricating a probe card according to the present invention;
Fig. 6 is a plane view showing the probe card according to the present invention;
Fig. 7 is a perspective view showing the probe card used in the diagnosis for an integrated circuit device;
Fig. 8 is a cross sectional view showing the structure of a membrane probe card according to the present invention; and
Figs. 9A to 9D are cross sectional views showing a process for fabricating another probe card according to the present invention.

### DESCRIPTION OF THE PREFERRED EMBODIMENTS

### First Embodinient

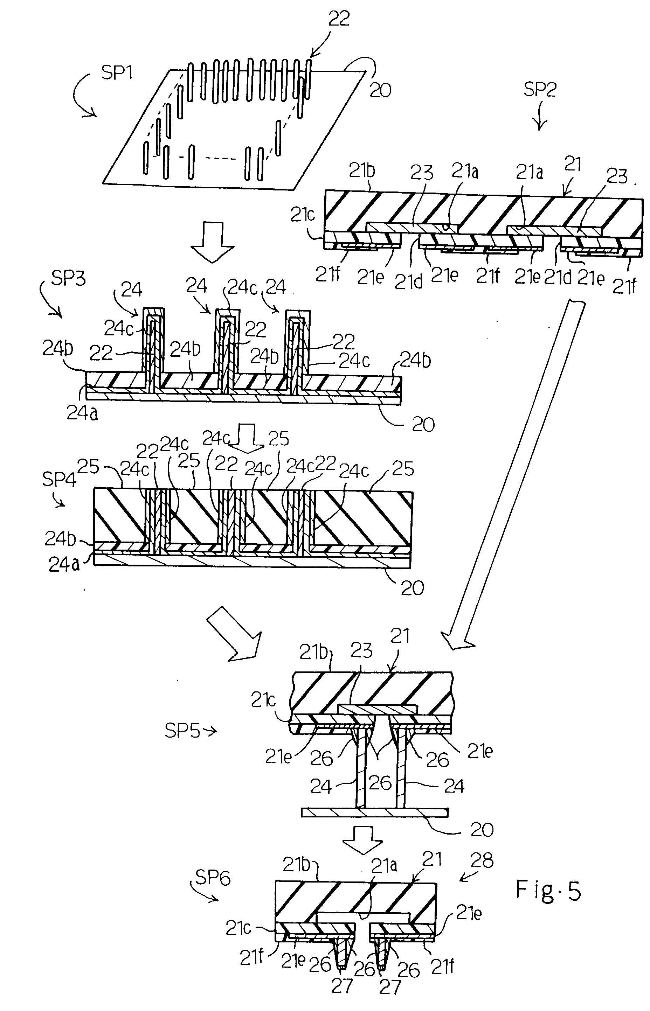

Referring first to figure 5 of the drawings, a process for fabricating a probe card embodying the present invention starts with preparation of a silicon wafer 20 and a ceramic substrate 21. The process sequence includes the following steps SP1, SP2, SP3, SP4, SP5 and SP6. Step SP2 is carried out between the preparation step and step SP5. A silicon wafer 20 on which silicon whiskers 22 have been already grown is commercially available for the probe card.

In step SP1, silicon whiskers 22 are grown on a silicon wafer 20, or the silicon wafer 20 on which the silicon whiskers 22 have been already grown is prepared. Grooves 21a are formed in the ceramic substrate 21, and silver fills in the grooves 21a so as to form silver layers 23. A multi-level wiring structure is fabricated on the ceramic substrate 21 in step SP2. Needle-like conductive posts 24 are made by using the silicon whiskers 22 in step SP3. The needle-like conductive posts 24 are protected by using wax 25, and, thereafter, the resultant structure is polished so as to make all the needle-like conductive posts 24 of uniform height in step SP4. The needle-like conductive posts 24 are bonded to the multi-level wiring structure on the ceramic substrate 21 as by step SP5, and the needle-like conductive posts 24 are cut from the silicon wafer 20. Finally, the silver is removed from the ceramic substrate 21, and the silver is evacuated from the grooves 21a as by step SP6.

The process sequence was detailed by the present inventors as follows. The present inventors prepared a 6-inch silicon wafer 21 on which the silicon whiskers 22 have been already grown as by step SP1. The 6-inch silicon wafer 21 was sold by Electric Chemical Industry Corporation. The silicon whiskers 22 were arranged in such a manner as to be aligned with electrodes on an integrated circuit device to be diagnosed, and were 25 microns in diameter and 1 millimeter in height.

The present inventors prepared a ceramic plate 21b, and the grooves 21a were formed on a surface of the ceramic plate 21b. The grooves 21a are filled with silver paste, and the silver paste was fired at 700 degrees in centigrade. The resultant ceramic structure was polished, and the silver strips 23 and the ceramic plate 21b created a smooth surface. Polyimide was spun onto the smooth surface, and the smooth surface was covered with a polyimide layer 21c. Photo-resist solution was spun onto the polyimide layer 21c, and a pattern image for openings was transferred to the photo-resist layer (not shown). The latent image was developed, and a photo-resist etching mask (not shown) was formed on the polyimide layer. The polyimide layer was selectively etched away so as to form openings 21d, and the silver layers 23 were exposed to the openings 21d. Chromium was deposited to 0.1 micron thick on the entire surface of the resultant ceramic structure by using sputtering, and palladium was further deposited to 0.1 micron thick on the chromium layer by sputtering. Thus, the chromium layer and the palladium layer were laminated on the patterned polyimide layer 21c and the exposed areas of the silver strips 23. Photo-resist solution was spun onto the palladium layer, and a pattern image for conductive strips was transferred to the photo-resist layer. The latent image was developed, and a photo-resist lift-off mask was prepared on the palladium layer. Copper, nickel and gold were plated to 1 micron thick, 5 microns thick and 2 microns thick on the conductive strips, respectively, and the photo-resist lift-off mask was removed. Using the multi-layer patterned structure of copper/nickel/gold as an etching mask, the palladium layer and the chromium layer were selectively etched away so that conductive wiring layers 21e are left on the polyimide layer 21c. Polyimide was spun onto the resultant ceramic structure, and a photo-resist etching mask (not shown) was patterned on the polyimide layer 21f through the lithography and the etching. As a result, the areas of the silver layers 23 were exposed, again, and parts of the conductive wiring layers 21e were uncovered with the polyimide layer 21f. In this way, the ceramic substrate 21 was obtained in step SP2.

Subsequently, the needle-like conductive posts 24 were made from the silicon whiskers 22 in step SP3 as follows. Firstly, chromium was deposited to 0.1 micron thick on the silicon wafer 20 and the silicon whiskers 22 by using sputtering, and palladium was further deposited to 0.1 micron thick on the chromium layer by using sputtering. The silicon wafer 20 and the silicon whiskers 22 were covered with a composite conductive layer 24a. The composite conductive layer 24a on the silicon wafer 20 was covered with photo-resist. However, the composite conductive layer 24a on the silicon whiskers 22 still projected from the photo-resist layer 24b. Nickel and palladium were plated on the composite conductive layer 24a on the silicon whiskers 22 by 2 microns thick and 3 microns thick through an electroplating. Then, the composite conductive layer 24a on the silicon whiskers 22 were covered with composite layers 24c of nickel/palladium, and the needle-like conductive posts 24 were obtained in step SP3.

The resultant structure at step SP3 was placed in a vacuum chamber (not shown), and wax 25 flowed into the gap between the needle-like conductive posts 24 at 100 degrees centigrade. The wax 25 was cooled to room temperature, and formed a protective resin layer. The resultant structure was polished so as to make the needle-like conductive posts 24 uniform in thickness. The dispersion of height was not greater than 3 microns.

Subsequently, the resultant structure at step SP4 was assembled with the ceramic substrate 21 as follows. First, the wax 25 was heated, and flowed out from the structure, and the resultant structure was cleaned by using organic solvent. The resultant structure after the removal of the wax 25 will hereinbelow referred to as "silicon wafer structure". The needle-like conductive posts 24 were brought into contact with the exposed areas of the conductive wiring layers 21e, and were soldered to the exposed areas. Indium soldering pieces 26 were heated to 170 degrees in centigrade, and bonded the needle-like conductive posts 24 to the exposed areas of the conductive wiring layers 21e. The indium solder was melted at low temperature, and the needle-like conductive posts 24 and the conductive wiring layers 21e were exactly assembled without misalignment due to the difference in thermal expansion coefficient between the silicon and the ceramic. Thus, the needle-like conductive posts 24 were fixed to the ceramic substrate 21 in step SP5.

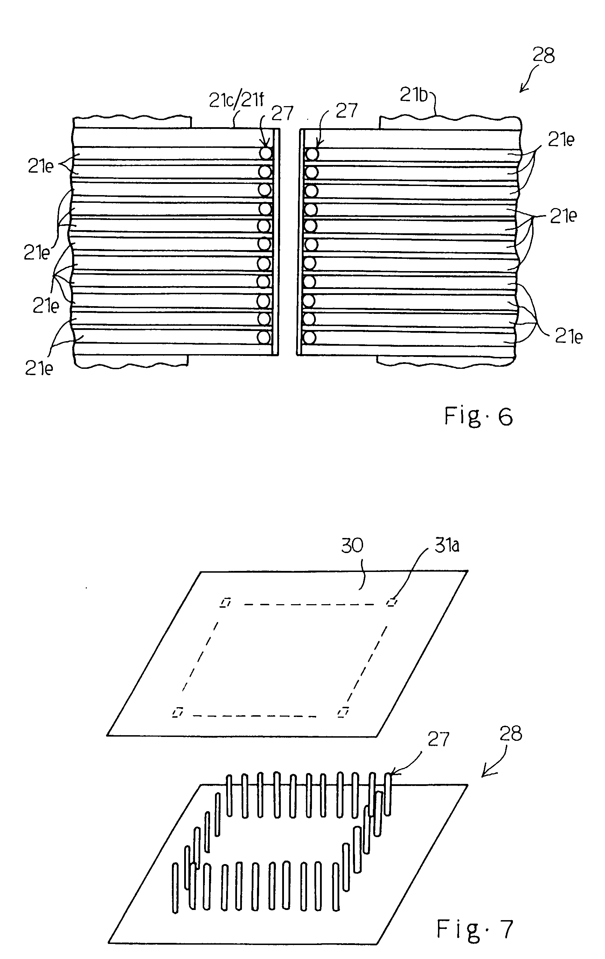

Subsequently, wax filled the gap between the ceramic substrate 21 and the silicon wafer structure, and was cooled to room temperature. Thus, a protective wax layer (not shown) was inserted between the ceramic substrate 21 and the silicon wafer structure. The needle-like conductive posts 24 were cut at 150 microns from the ceramic substrate 21. Needle-like conductive stumps 27 were left on the composite conductive wiring layers 21e. The needle-like conductive stumps 27 were polished so that the dispersion of height was equal to or less than 3 microns. The wax layer was removed by applying heat, and the needle-like conductive stumps 17 were cleaned by using the organic solvent. Nickel and palladium were plated to 2 microns thick and 3 microns thick, respectively, on the exposed surface of the silicon whiskers 22 by using the electroplating, and needle-like probes 27 were completed. The resultant structure was dipped into copper nitrate, and the silver layers 23 were biased to +3 volts. The silver was etched away, and a probe card 28 was completed. The needle-like probes 27 were arranged as shown in figure 6. The aspect ratio of the needle-like probes 27 were much greater than 1.

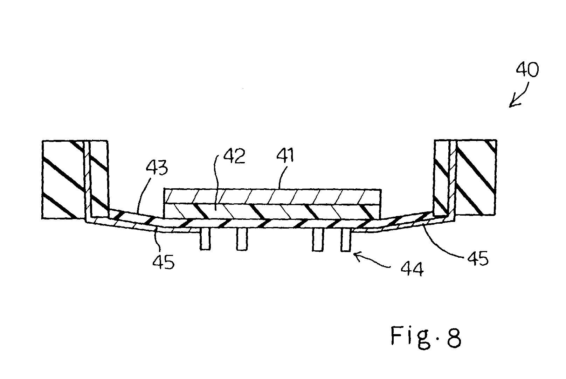

Using the probe card 28 shown in figures 5 and 6, a semiconductor integrated circuit device was diagnosed. The probe card 28 was installed in a testing apparatus (not shown), and the needle-like probes 27 were upwardly directed. The semiconductor integrated circuit device 30 was fabricated on a semiconductor wafer. The semiconductor wafer was conveyed over the probe card 28, and the electrodes 30a of the semiconductor integrated circuit device 30 were aligned with the needle-like probes 27 as shown in figure 7. The semiconductor wafer was moved down toward the probe card 28, and the electrodes 30a of the semiconductor integrated circuit device 30 were brought into contact with the needle-like probes 27. The needle-like probes 27 were supported on the composite conductive wiring layers 21e in a cantilever fashion, and the composite conductive wiring layers 21e were placed over the deformable polyimide layer 21c. Even though the semiconductor wafer was warped and the top surfaces of the electrodes 30a were not on a virtual flat plane, the composite conductive wiring layers 21e and the polyiniide layer 21c were deformed, and absorbed the irregularity of the electrodes 30a. For this reason, the needle-like probes 27 were surely brought into contact with the electrodes, and a testing apparatus exactly diagnosed the semiconductor integrated circuit device 30. The present inventors confirmed that the composite conductive wiring layers 21e and the polyimide layer 21c absorbed the irregularity equal to or greater than 30 microns.

The present inventors further confirmed that the probe card had good durability. Eighty-one chips were fabricated in 100 millimeter square on a silicon wafer, and 2400 electrodes were arranged at the minimum pitch of 100 microns. The electrodes were pressed against the needle-like probes a million times. However, the needle-like probes were not damaged.

In the above described embodiment, the first portion is implemented by the cantilever over the groove 21a, and the remaining portion of the ceramic plate 21a serves as the second portion.

### Second Embodiment

Turning to figure 8 of the drawings, a membrane probe card 40 embodying the present invention comprises a supporting substrate 41, an elastomer layer 42, a film 43, the needle-like probes 44 and conductive wiring layers 45. The needle-like probes 44 are 15 microns in diameter and 50 microns in height at pitch of 40 microns, and are produced in a similar way.

The present inventor confirmed that the membrane probe card 40 absorbed the irregularity of 10 microns by virtue of the elastomer layer. The present inventors further confirmed that the needle-like probes 44 were not damaged after the contact with 800 electrodes of 16 chips fabricated in 50 millimeter square at the minimum pitch of 40 microns repeated a million times.

### Third Embodiment

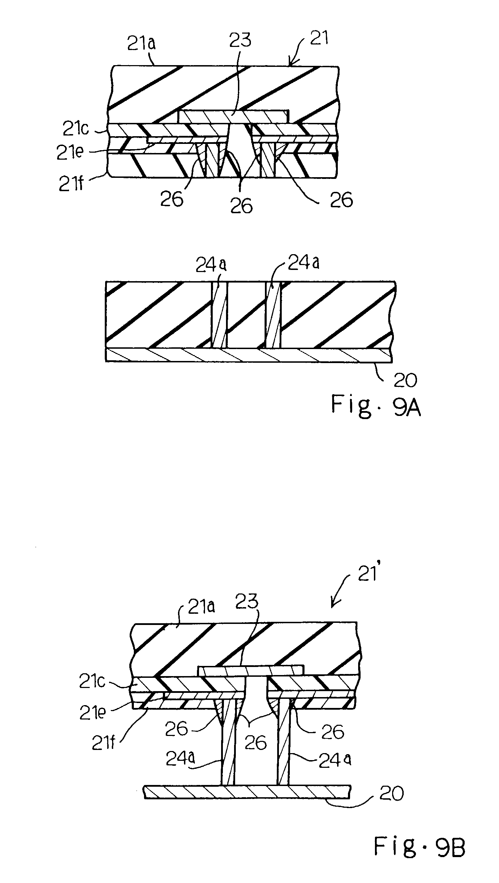

Figures 9A to 9D illustrate essential steps of a process sequence for fabricating a probe card embodying the present invention. The process sequence implementing the third embodiment is similar to the process sequence shown in figure 5 until the step of cutting the needle-like conductive posts shown in figure 9A. The needle-like conductive stumps are embedded in the reinforcing wax layer over the ceramic substrate 21, and remaining needle-like posts 24a are also embedded in the reinforcing wax layer on the semiconductor wafer 20.

The remaining semiconductor wafer structure shown in figure 9A is used for another probe card as follows. The reinforcing was layer is removed from the remaining semiconductor wafer structure, and the remaining needle-like posts 24a are exposed, again. Another ceramic substrate 21' is prepared, and the remaining needle-like posts 24a are soldered to the conductive wiring layers 21e as shown in figure 9B.

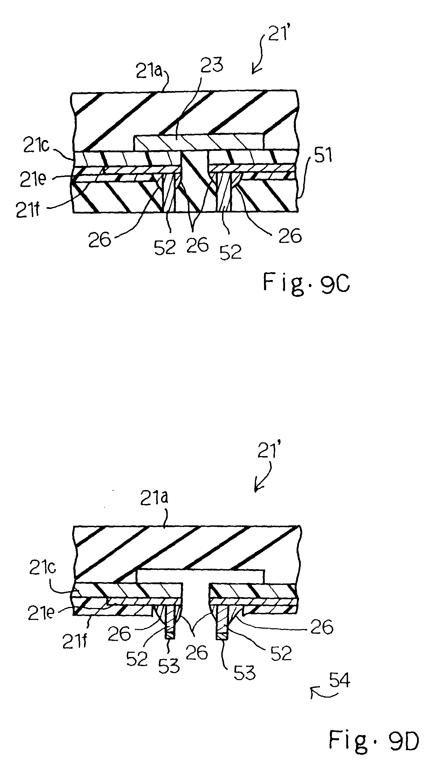

Wax 51 fills the gap between the ceramic substrate 21a' and the remaining semiconductor wafer structure so as to reinforce the needle-like conductive posts 24a, and the remaining needle-like conductive posts 24a are cut at 150 microns from the ceramic substrate 21'. The conductive stumps 52 are left in the reinforcing wax layer 51 as shown in figure 9C.

The reinforcing wax layer 51 is melted away, and the resultant structure is cleaned in the organic solvent. The conductive stumps 52 are covered with a nickel film of 2 microns thick and a palladium film of 3 microns thick by using the electroplating, and the composite nickel/palladium film 53 and the conductive stumps 52 form in combination needle-like conductive probes 54. Finally, the silver layers 23 are etched away, and the conductive wiring layers 21e are provided on the polyimide layer 21c in a cantilever fashion as shown in figure 9D.

The present inventors confirmed that the probe card implementing the third embodiment was effective against the irregularity and durable as similar to the probe card implementing the first embodiment.

Thus, the probe card achieves all the advantages of the first embodiment, and the process is rather economical than that of the first embodiment. For this reason, the probe card implementing the third embodiment is lower in production cost than that of the first embodiment.

As will be appreciated from the foregoing description, the needle-like conductive probes are arranged at fine pitch, because the needle-like conductive probes are controllable between 10 microns thick to 30 microns thick.

The needle-like conductive probes have an aspect ratio much greater than 1, and the long probes allows the manufacturer to increase the stroke of the semiconductor wafer. In other words, the manufacturer can widely move the semiconductor wafer.

The needle-like conductive probes 27/44 are mounted on the polyimide layer 21c or the elastomer layer 42, and the deformable polyiniide/elastomer layers 21c/42 absorbs the irregularity of the electrodes. For this reason, the electrodes are surely brought into contact with the needle-like conductive probes 27/44, and the testing apparatus exactly diagnoses the semiconductor integrated circuit device. Especially, the needle-like conductive probes 27 are mounted on the conductive wiring layers 21e in the cantilever fashion, and the conductive wiring layers 21e are widely deformed. For this reason, the needle-like conductive probes 27 allows the electrodes on the semiconductor integrated circuit device to have larger irregularity.

The wax may flow into the gap in the atmospheric pressure in so far as the wax is melted at or lower than 100 degrees in centigrade.

Although particular embodiments of the present invention have been shown and described, it will be obvious to those skilled in the art that various changes and modifications may be made without departing from the spirit and scope of the present invention.

For example, the needle-like conductive posts may be used more than twice.

## Claims

1. A probe card for testing a semiconductor integrated circuit (30) having electrodes (31a), comprising:
a rigid substrate (21b; 41) having a first portion;
a conductive wiring structure (21e; 45) formed on said resilient layer; and
a plurality of needle-like conductive probes (27; 44) connected to said conductive wiring structure, and each including a silicon whisker projecting in a vertical direction to said first portion and a conductive layer covering said silicon whisker,
characterized by
a resilient layer (21c; 42) inserted between said rigid substrate and said conductive wiring structure under said plurality of needle-like conductive probes.

2. The probe card as set forth in claim 1, in which said first portion projects from a second portion of said rigid substrate in a cantilever fashion.

3. The probe card as set forth in claim 2, in which said plurality of needle-like conductive probes (27; 44) have an aspect ratio greater than 1.

4. The probe card as set forth in claim 3, in which said rigid substrate is formed of ceramic, and said resilient layer is formed of organic compound.

5. The probe card as set forth in claim 1, in which said resilient layer (21c; 42) is formed of material selected from the group consisting of polyimide and elastomer.

6. The probe card as set forth in claim 1, in which said rigid substrate (41), said resilient layer (42) and said plurality of needle-like conductive probes (44) form parts of a membrane probe card.

7. The probe card as set forth in claim 1, in which said plurality of needle-like conductive probes (27) are fixed to said conductive wiring structure by using low fusing point solder (26).

8. The probe card as set forth in claim 7, in which said low fusing point solder (26) mainly consists of indium.

9. A process for fabricating a probe card, comprising the steps of:
a) preparing a rigid substrate (21b) having a groove (21a) filled with a certain material;
b) forming a resilient layer (21c) extending over said rigid substrate and the layer (23) of said certain material;
c) forming a conductive wiring layer structure (21e) on said resilient layer having a hole (21d) where said layer of said certain material is exposed;
f) connecting needle-like conductive probes (27) formed from silicon whiskers to said conductive wiring layer structure; and
removing said certain material for evacuating said layer (23) of said certain material from said groove (21a) so as to provide said needle-like conductive probes (27) over said resilient layer (21c) supported by said rigid substrate in a cantilever fashion.

10. The process as set forth in claim 9, in which said step d) includes the sub-steps of
d-1) preparing a semiconductor wafer structure (20) having needle-like conductive posts (24) having silicon whiskers (22) respectively covered with conductive layers (24a/24c),
d-2) bonding said needle-like conductive posts (24) to said conductive wiring layer structure (21e),
d-3) cutting said needle-like conductive posts (24) so as to form conductive stumps on said conductive wiring layer structure, and
d-4) forming said needle-like conductive probes (27) from said conductive stumps.

11. The process as set forth in claim 10, in which the remaining semiconductor wafer structure at said step d-4) is used as said semiconductor wafer structure in step d-1), again, and said step d-2), d-3), d-4) and e) are repeated for another rigid substrate for producing another probe card.

12. The process as set forth in claim 10, in which said certain material is silver, and said resilient material is organic compound.

13. The process as set forth in claim 10, in which said needle-like conductive posts (24) are bonded to said conductive wiring layer structure (21e) by using low fusing point solder (26).

14. The process as set forth in claim 13, in which said low fusing point solder (26) mainly consist of indium.
